# EUROPEAN PATENT APPLICATION

(11) **EP 2 988 143 A1**
(43) Date of publication of application: **24.02.2016**
(21) Application number: 14275171.8
(22) Date of filing: 19.08.2014
(51) Int. Cl.: G01R 31/333, H02M 7/483

(54) **Synthetic test circuit**

(71) Applicant: ALSTOM Technology Ltd, 5400 Baden (CH)
(72) Inventor: Trainer, David Reginald, Alvaston, Derby DE240AQ (GB); Dang, Si, Stafford ST162EB (GB); Moreno Muñoz, Francisco Jose, Stafford ST162QZ (GB)
(74) Representative: Potter Clarkson LLP

(57) **Abstract**

A synthetic test circuit (30), for performing an electrical test on a device (52) under test, comprises:
a terminal (32,34) connectable to the device (52) under test;
a voltage injection circuit (40) operably connected to the terminal (32,34), the voltage injection circuit (40) including a voltage source, the voltage source including a chain-link converter, the chain-link converter including a plurality of modules, each module including at least one energy storage device; and
a controller (50) configured to operate each module of the voltage injection circuit (40) to selectively bypass the or each corresponding energy storage device and insert the or each corresponding energy storage device into the chain-link converter so as to generate a voltage across the chain-link converter and thereby operate the voltage injection circuit (40) to inject a unidirectional voltage waveform into the device (52) under test.

## Description

This invention relates to a synthetic test circuit for performing an electrical test on a device under test, in particular a synthetic test circuit for performing an electrical test on a switching element for use in high voltage direct current (HVDC) power transmission.

It is known to employ a synthetic test circuit to test a switching element for use in HVDC power transmission. The term "synthetic" is used to describe the test circuit because the test circuit does not form part of an actual HVDC station converter, i.e. the switching element under test is not connected into the actual HVDC station converter which transfers significant real power.

According to an aspect of the invention, there is provided a synthetic test circuit, for performing an electrical test on a device under test, comprising:
a terminal connectable to the device under test;
a voltage injection circuit operably connected to the terminal, the voltage injection circuit including a voltage source, the voltage source including a chain-link converter, the chain-link converter including a plurality of modules, each module including at least one energy storage device; and
a controller being configured to operate each module of the voltage injection circuit to selectively bypass the or each corresponding energy storage device and insert the or each corresponding energy storage device into the chain-link converter so as to generate a voltage across the chain-link converter and thereby operate the voltage injection circuit to inject a unidirectional voltage waveform into the device under test.

The structure of the chain-link converter (which may, for example, comprise a plurality of series-connected modules) permits build-up of a combined voltage across the chain-link converter, which is higher than the voltage available from each of its individual modules, via the insertion of the energy storage devices of multiple modules, each providing its own voltage, into the chain-link converter. In this manner the chain-link converter is capable of providing a stepped variable voltage source, which permits the generation of a voltage waveform across the chain-link converter using a step-wise approximation. As such the chain-link converter is capable of providing complex voltage waveforms to enable the voltage injection circuit to inject a wide range of unidirectional voltage waveforms into the device under test, and so enables the synthetic test circuit to readily and reliably create test voltage conditions that are identical or closely similar to actual in-service voltage conditions. More particularly the operation of the voltage injection circuit to inject a unidirectional voltage waveform into the device under test permits the synthetic test circuit to readily and reliably create test unidirectional voltage conditions that are identical or closely similar to actual in-service unidirectional voltage conditions.

In addition the capability of the chain-link converter to generate a voltage waveform thereacross using a step-wise approximation allows the voltage injection circuit to inject unidirectional voltage waveforms of varying levels into the device under test, and thus renders the synthetic test circuit capable of electrically testing various devices across a wide range of device ratings.

Furthermore the modular arrangement of the chain-link converter means that the number of modules in the chain-link converter can be readily scaled up or down to modify the voltage capability of the chain-link converter to match the testing requirements of the device under test, without having to make significant changes to the overall design of the synthetic test circuit.

The provision of the chain-link converter in the voltage injection circuit therefore results in a synthetic test circuit that is not only capable of performing high quality electrical testing, but also has the flexibility to perform an electrical test on a broad range of devices with different device ratings.

In a preferred embodiment of the invention, the voltage source may be a unidirectional voltage source. The provision of the unidirectional voltage source in the voltage injection source results in a synthetic test circuit that is specifically optimised for injecting a unidirectional voltage waveform into the device under test.

The structure of each module of the chain-link converter of the voltage injection circuit may vary to meet the testing requirements of the device under test.

Each module of the voltage injection circuit may include a plurality of module switches connected with the or each energy storage device to define a unipolar module that can provide zero or positive voltages.

Optionally each module of the voltage injection circuit may include a plurality of module switches connected in parallel with an energy storage device in a half-bridge arrangement to define a unipolar module that can provide zero or positive voltages.

Further optionally each module of the voltage injection circuit may include a plurality of module switches connected in parallel with an energy storage device in a half-bridge arrangement to define a 2-quadrant unipolar module that can provide zero or positive voltages and can conduct current in two directions.

In embodiments of the invention, the synthetic test circuit may further include a current injection circuit operably connected to the terminal, the current injection circuit including a current source, the current source including a chain-link converter, the chain-link converter including a plurality of modules, each module including at least one energy storage device. In such embodiments the controller may be configured to operate each module of the current injection circuit to selectively bypass the or each corresponding energy storage device and insert the or each corresponding energy storage device into the chain-link converter so as to generate a voltage across the chain-link converter and thereby operate the current injection circuit to inject a current waveform into the device under test.

In a similar fashion to that of the voltage injection circuit, the structure of the chain-link converter enables the current injection circuit to inject a wide range of current waveforms into the device under test, and so enables the synthetic test circuit to readily and reliably create test current conditions that are identical or closely similar to actual in-service current conditions.

In embodiments employing the use of a current injection circuit, the controller may be configured to operate each module of the current injection circuit to selectively bypass the or each corresponding energy storage device and insert the or each corresponding energy storage device into the chain-link converter so as to generate a voltage across the chain-link converter and thereby operate the current injection circuit to inject a voltage waveform into the device under test.

The ability to operate the current injection circuit to inject a voltage waveform into the device under test provides a further option for testing the voltage capabilities of the device under test, thus enhancing the electrical testing capabilities of the synthetic test circuit.

In further embodiments of the invention, the current source may be a bidirectional current source. This enables the current injection circuit to inject a bidirectional current waveform into the device under test.

In still further embodiments of the invention, the current source may include an inductor connected to the chain-link converter.

The inclusion of the inductor in the current source provides a current control element for improving control over the injection of a current waveform into the device under test.

The structure of each module of the chain-link converter of the current injection circuit may vary to meet the testing requirements of the device under test.

Each module of the current injection circuit may include a plurality of module switches connected with the or each energy storage device to define a bipolar module that can provide negative, zero or positive voltages.

Optionally each module of the current injection circuit may include a plurality of module switches connected in parallel with an energy storage device in a full-bridge arrangement to define a bipolar module that can provide negative, zero or positive voltages.

Further optionally each module of the current injection circuit may include a plurality of module switches connected in parallel with an energy storage device in a full-bridge arrangement to define a 4-quadrant bipolar module that can provide negative, zero or positive voltages and can conduct current in two directions.

In order to be certified for service operation, a device must comply with various testing requirements.

In embodiments of the invention the controller may be configured to operate the voltage and current injection circuits to inject a unidirectional voltage waveform and a current waveform respectively into the device under test so as to perform at least one cycle of sequential injections of the unidirectional voltage and current waveforms into the device under test, and a changeover between an injection of the voltage waveform into the device under test and an injection of the current waveform into the device under test takes place at a non-zero, zero or substantially zero value of the current waveform and at a non-zero, zero or substantially zero value of the unidirectional voltage waveform.

In further embodiments of the invention the controller is configured to operate the current injection circuit to inject voltage and current waveforms into the device under test so as to perform at least one cycle of sequential injections of the voltage and current waveforms into the device under test, and a changeover from an injection of the voltage waveform into the device under test and an injection of the current waveform into the device under test takes place at a non-zero, zero or substantially zero value of the current waveform and at a non-zero, zero or substantially zero value of the voltage waveform.

The configuration of the controller to enable performance of at least one cycle of sequential injections of the voltage and current waveforms into the device under test enables the synthetic test circuit to create test conditions that are identical or closely similar to actual in-service conditions in which the device experiences a changeover between varying voltage and current conditions.

For example, when the device is a switching element, the changeover between an injection of the voltage waveform into the switching element under test and an injection of the current waveform into the switching element under test takes place at:
- a zero or substantially zero value of the current waveform and at a zero or substantially zero value of the voltage waveform to create test conditions that are identical or closely similar to soft current switching and soft voltage switching of the switching element;
- a zero or substantially zero value of the current waveform and at a non-zero value of the voltage waveform to create test conditions that are identical or closely similar to soft current switching and hard voltage switching of the switching element;
- a non-zero value of the current waveform and at a zero or substantially zero value of the voltage waveform to create test conditions that are identical or closely similar to hard current switching and soft voltage switching of the switching element; and
- a non-zero value of the current waveform and at a non-zero value of the voltage waveform to create test conditions that are identical or closely similar to hard current switching and hard voltage switching of the switching element.

Performing a single cycle of sequential injections of the voltage and current waveforms into the device under test permits creation of test conditions that are identical or closely similar to actual in-service conditions that occur on a single-shot or infrequent basis, such as those occurring under emergency or abnormal circumstances.

Performing two or more cycles of sequential injections of the voltage and current waveforms into the device under test permits creation of test conditions that are identical or closely similar to actual in-service conditions that occur on a repetitive basis, such as those occurring during normal operation of the device.

In still further embodiments of the invention the controller may be configured to operate the voltage injection circuit, when the current injection circuit is operated to inject a current waveform into the device under test, to selectively permit the injected current waveform to flow through the voltage injection circuit and block the injected current waveform from flowing through the voltage injection circuit so as to allow the injected current waveform to commutate between the device under test and voltage injection circuit.

Such commutation of the injected current waveform between the device under test and voltage injection circuit provides the synthetic test circuit with a reliable means for creating test current conditions that are identical or closely similar to actual in-service current conditions in which the device experiences a changeover at a non-zero value of the current waveform.

The synthetic test circuit may be rated for performing an electrical test on a switching element, the switching element being preferably a switching element for use in high voltage direct current (HVDC) power transmission.

The synthetic test circuit may further include an isolation switch that is switchable to selectively isolate the current injection circuit from the voltage injection circuit and device under test when the voltage injection circuit is injecting the unidirectional voltage waveform into the device under test. The provision of the isolation switch permits the current injection circuit to be configured as a low voltage, high current injection circuit, and the voltage injection circuit to be configured as a low current, high voltage injection circuit.

Optionally the voltage rating of the chain-link converter of the current injection circuit may exceed the voltage rating of the chain-link converter of the voltage injection circuit. This allows the current injection circuit to selectively provide a blocking voltage to isolate the current injection circuit from the voltage injection circuit and device under test, thus obviating the need for the isolation switch.

Preferred embodiments of the invention will now be described, by way of non-limiting examples, with reference to the accompanying drawings in which:
Figure 1 a and 1 b shows schematically a synthetic test circuit according to a first embodiment of the invention;
Figures 2a and 2b shows schematically the structures of the 4-quadrant bipolar module and 2-quadrant unipolar module respectively;
Figures 3 and 4 illustrate the basic operations of the current and voltage injection circuits of Figure 2;
Figures 5 and 6 show schematically examples of voltage source converters for use in HVDC power transmission;
Figure 7 illustrates actual in-service soft current switching and soft voltage switching conditions experienced by a switching element in both inverter and rectifier modes of an Alternate Arm Converter;
Figure 8 illustrates the operation of the voltage and current injection circuits of Figure 1 a to inject respective voltage and current waveforms into a switching element under test to create test conditions corresponding to the actual in-service soft current switching and soft voltage conditions of Figure 7;
Figure 9 illustrates actual in-service soft current switching and hard voltage conditions experienced by a switching element in both inverter and rectifier modes of an Alternate Arm Converter;
Figure 10 illustrates the operation of the voltage and current injection circuits of Figure 1 a to inject respective voltage and current waveforms into a switching element under test to create test conditions corresponding to the actual in-service soft current switching and hard voltage conditions of Figure 9;
Figure 11 illustrates the operation of the current injection circuit of Figure 1 a to inject both voltage and current waveforms into a switching element under test to create test conditions corresponding to the actual in-service soft current switching and soft voltage conditions of Figure 7;
Figure 12 illustrates the operation of the voltage and current injection circuits of Figure 1 a to create a step change in current injected into a switching element under test to create test conditions corresponding to actual in-service hard current switching conditions;
Figures 13 and 14 illustrate the operation of the voltage and current injection circuits of Figure 1 a to inject respective voltage and current waveforms into a switching element under test to create test conditions corresponding to hard current switching and soft voltage switching conditions;
Figure 15 illustrates, in graph form, simulation results of the creation of the test conditions of Figures 13 and 14;
Figures 16 and 17 illustrate the operation of the voltage and current injection circuits of Figure 1 a to inject respective voltage and current waveforms into a switching element under test to create test conditions corresponding to hard current switching and hard voltage switching conditions;
Figure 18 illustrates, in graph form, simulation results of the creation of the test conditions of Figures 16 and 17; and
Figure 19 shows schematically a synthetic test circuit according to a second embodiment of the invention.

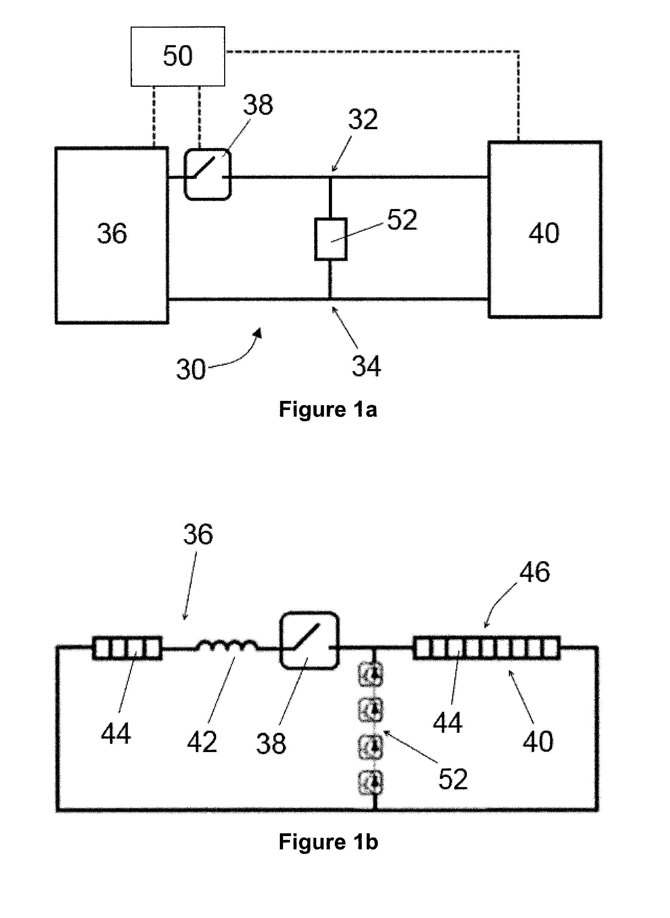

A synthetic test circuit according to a first embodiment of the invention is shown in Figures 1 a and 1 b, and is designated generally by the reference numeral 30.

The synthetic test circuit 30 comprises first and second terminals 32,34, a current injection circuit 36, an isolation switch 38 and a voltage injection circuit 40. As shown in Figures 1 a and 1 b, the current injection circuit 36 is connected in series with the isolation switch 38 between the first and second terminals 32,34, and the voltage injection circuit 40 is connected between the first and second terminals 32,34, and is thereby connected in parallel with the series connection of the current injection circuit 36 and isolation switch 38.

The current injection circuit 36 includes a current source. The current source includes a series connection of an inductor 42 and a chain-link converter 44.

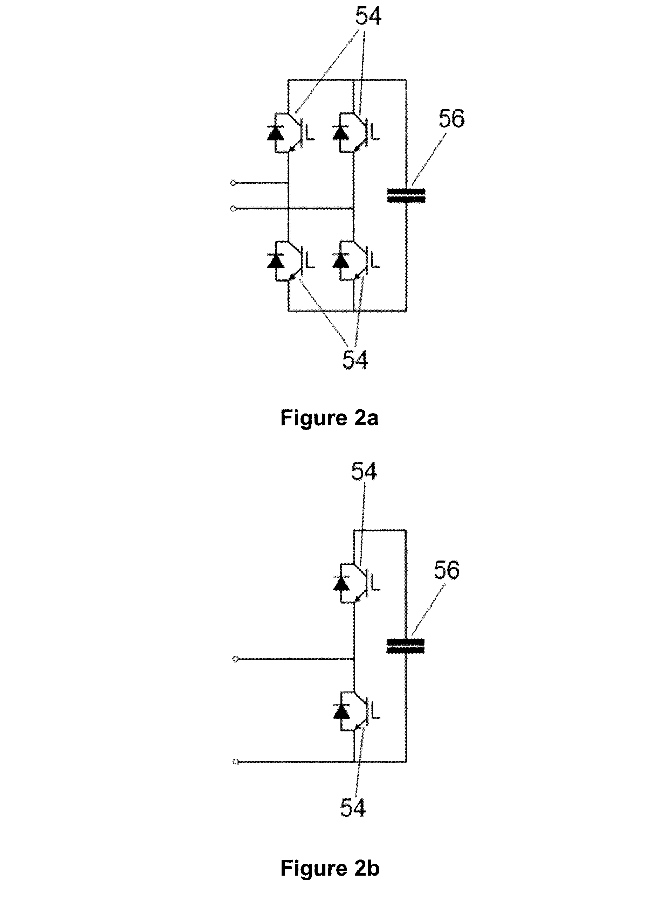

The chain-link converter 44 of the current injection circuit includes a plurality of series-connected modules. Each module includes two pairs of module switches 54 and an energy storage device in the form of a capacitor 56. In each module, the pairs of module switches 54 are connected in parallel with the capacitor 56 in a full-bridge arrangement to define a 4-quadrant bipolar module that can provide negative, zero or positive voltages and can conduct current in two directions. Figure 2a shows the structure of the 4-quadrant bipolar module.

The capacitor 56 of each module of the current injection circuit is selectively bypassed and inserted into the chain-link converter 44 by changing the states of the corresponding module switches 54. This selectively directs current through the capacitor 56 or causes current to bypass the capacitor 56 so that the module provides a negative, zero or positive voltage.

The capacitor 56 of the module is bypassed when the module switches 54 are configured to form a current path that causes current in the respective chain-link converter 44 to bypass the capacitor 56, and so the module provides a zero voltage, i.e. the module is configured in a bypassed mode.

The capacitor 56 of the module is inserted into the respective chain-link converter 44 when the module switches 54 are configured to allow the current in the respective chain-link converter 44 to flow into and out of the capacitor 56. The capacitor 56 then charges or discharges its stored energy so as to provide a non-zero voltage, i.e. the module is configured in a non-bypassed mode. The full-bridge arrangement of the module switches permits configuration of the module switches 54 to cause current to flow into and out of the capacitor 56 in either direction, and so each module can be configured to provide a negative or positive voltage in the non-bypassed mode.

The voltage injection circuit 40 includes a voltage source 46. The voltage source 46 includes a chain-link converter 44.

The chain-link converter 44 of the voltage injection circuit 40 includes a plurality of series-connected modules. Each module includes one pair of module switches 54 and an energy storage device in the form of a capacitor 56. In each module, the pair of module switches 54 is connected in parallel with the capacitor 56 in a half-bridge arrangement to define a 2-quadrant unipolar module that can provide zero or positive voltages and can conduct current in two directions. Figure 2b shows the structure of the 2-quadrant unipolar module.

The capacitor 56 of each module of the voltage injection circuit 40 is selectively bypassed and inserted into the chain-link converter 44 by changing the states of the corresponding module switches 54. This selectively directs current through the capacitor 56 or causes current to bypass the capacitor 56 so that the module provides a zero or positive voltage.

The capacitor 56 of the module is bypassed when the module switches 54 are configured to form a current path that causes current in the respective chain-link converter 44 to bypass the capacitor 56, and so the module provides a zero voltage, i.e. the module is configured in a bypassed mode.

The capacitor 56 of the module is inserted into the respective chain-link converter 44 when the module switches 54 are configured to allow the current in the respective chain-link converter 44 to flow into and out of the capacitor 56. The capacitor 56 then charges or discharges its stored energy so as to provide a positive voltage, i.e. the module is configured in a non-bypassed mode.

The structure of each chain-link converter 44 permits build-up of a combined voltage across each chain-link converter 44, which is higher than the voltage available from each of its individual modules, via the insertion of the capacitors 56 of multiple modules, each providing its own voltage, into each chain-link converter 44. In this manner each chain-link converter 44 is capable of providing a stepped variable voltage source, which permits the generation of a voltage waveform across each chain-link converter 44 using a step-wise approximation. As such each chain-link converter 44 is capable of providing complex voltage waveforms.

Each module switch 54 constitutes an insulated gate bipolar transistor (IGBT) that is connected in anti-parallel with a diode. It is envisaged that, in other embodiments of the invention, each IGBT may be replaced by a gate turn-off thyristor, a field effect transistor, an injection-enhanced gate transistor, an integrated gate commutated thyristor or any other self-commutated switching device.

It is envisaged that, in other embodiments of the invention, each capacitor 56 may be replaced by another type of energy storage device that is capable of storing and releasing energy, e.g. a battery or fuel cell.

It is also envisaged that, in other embodiments of the invention, each of the current and voltage injection circuits 36,40 may include a different number and/or arrangement of chain-link converters 44.

The controller 50 is configured to control switching of the module switches 54 of each module to selectively bypass the corresponding capacitor 56 and insert the corresponding capacitor 56 into the corresponding chain-link converter 44 so as to generate a voltage across the corresponding chain-link converter 44.

The controller 50 is further configured to control switching of the isolation switch 38 to switch the current injection circuit 36 into and out of circuit with the first and second terminals 32,34 so as to selectively isolate the current injection circuit 36 from the device under test and the voltage injection circuit 40. The provision of the isolation switch 38 permits the current injection circuit 36 to be configured as a low voltage, high current injection circuit 36, and the voltage injection circuit 40 to be configured as a low current, high voltage injection circuit 40.

In use a switching element 52 under test, namely a switching element 52 in the form of a plurality of series-connected anti-parallel pairs of an IGBT and a diode that is for use in HVDC power transmission, is connected between the first and second terminals 32,34.

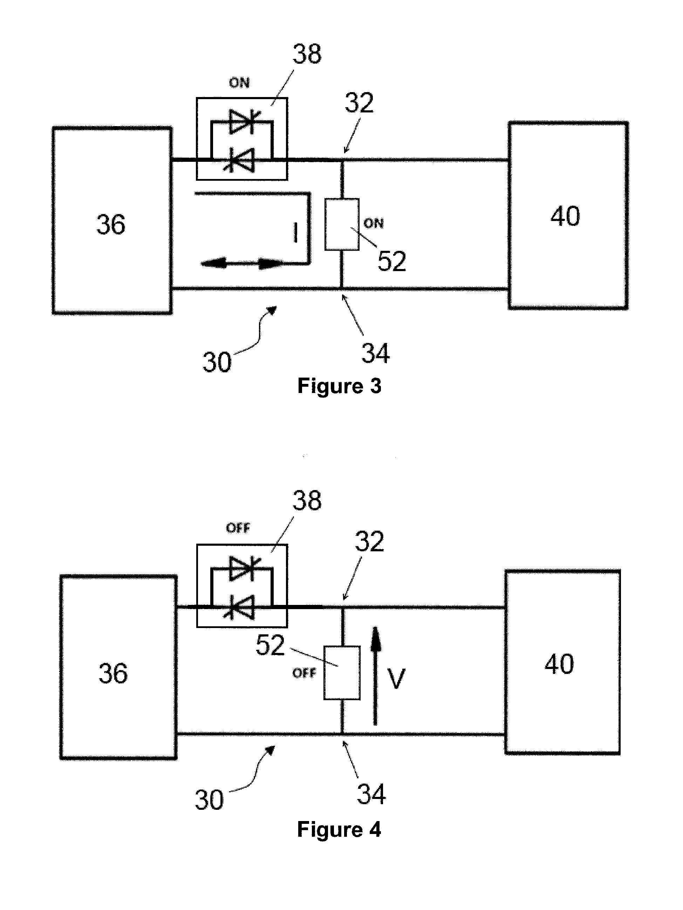

The configuration of the synthetic test circuit 30 as set out above enables the current injection circuit 36 to be operated to inject a bidirectional current waveform I into the switching element 52 under test, as shown in Figure 3, and enables the voltage injection circuit 40 to be operated to inject a unidirectional voltage waveform V into the switching element 52 under test, as shown in Figure 4. A cycle of such injections of current and voltage waveforms may be repeated at a desired frequency (e.g. 50 Hz).

Preferably, the isolation switch 38 is closed when the current injection circuit 36 is operated to inject the bidirectional current waveform I into the switching element 52 under test, and the isolation switch 38 is opened when the voltage injection circuit 40 is operated to inject the unidirectional voltage waveform V into the switching element 52 under test. Also preferably, when the switching element 52 under test is closed and carrying a positive or negative current injected by the current injection circuit, the controller 50 controls the switching of the module switches 54 of the voltage injection circuit 40 so as to block current from flowing through the voltage injection circuit 40 and thereby prevent the modules of the voltage injection circuit 40 from discharging into the switching element 52 under test. This means that the synthetic test circuit 30 would not be required to supply high voltage and high current at the same time, thus minimising the amount of power used during electrical testing of the switching element 52.

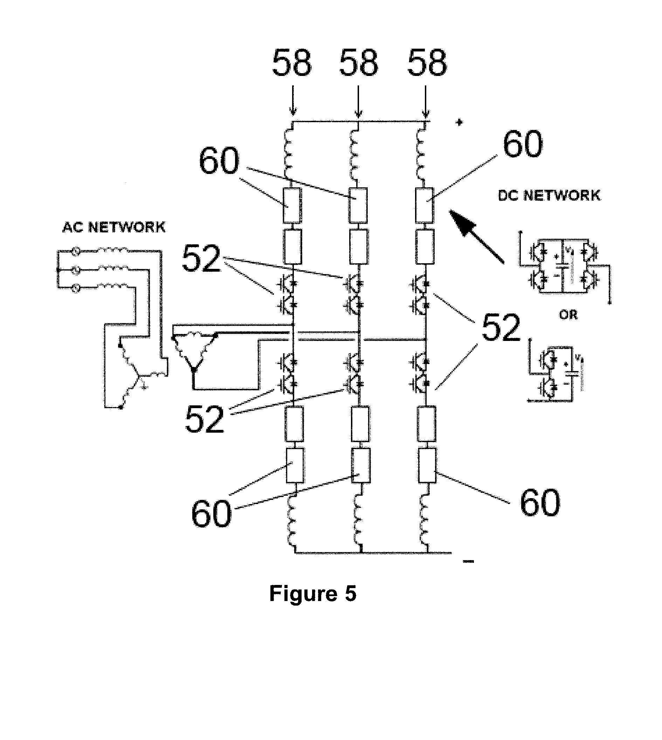

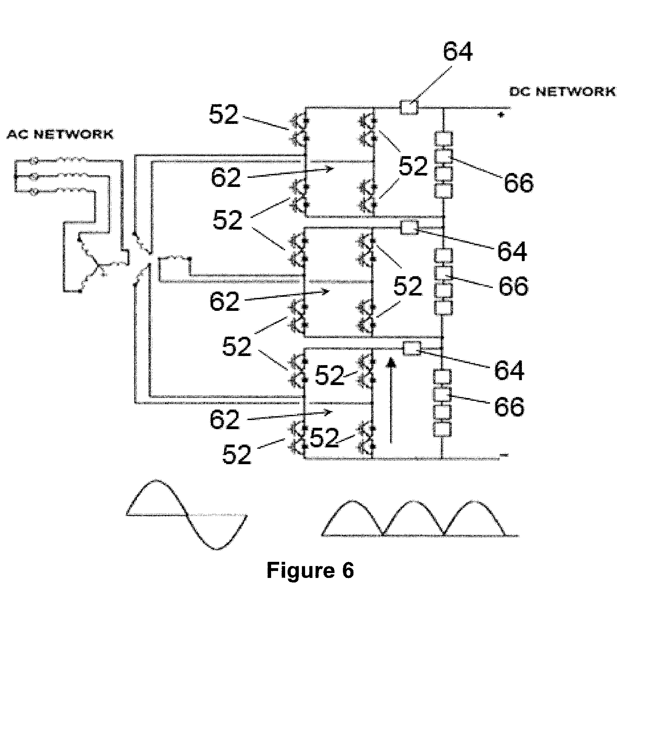

Figures 5 and 6 show, in schematic form, exemplary applications of the switching element 52 for use in HVDC power transmission.

In a first exemplary application shown in Figure 5, the switching element 52 forms part of an Alternate Arm Converter (AAC). The AAC includes a plurality of converter limbs 58, each of which extends between first and second DC terminals and includes first and second limb portions separated by a respective AC terminal. Each limb portion includes a switching element 52 connected in series with a chain-link converter 60. Each chain-link converter 60 includes a plurality of series-connected modules, each of which may be in the form of a 4-quadrant bipolar module or a 2-quadrant unipolar module. In use, the switching element 52 of each limb portion is operable to switch the corresponding limb portion into and out of circuit between the corresponding AC and DC terminals.

During such switching of each limb portion of the AAC, the corresponding switching element 52 commutates at zero current on a repetition cycle, typically at a frequency of 50 Hz.

The voltage experienced by each switching element 52 at its commutation may be either a zero (or substantially zero) voltage or a non-zero voltage depending on the reactive power being exchanged with an AC network connected to the AC terminals of the AAC. If the reactive power exchanged with the AC network is zero (or substantially zero), then the voltage experienced by each switching element 52 at its commutation is a zero (or substantially zero) voltage. If the reactive power exchanged with the AC network is non-zero, then the voltage experienced by each switching element 52 at its commutation is a non-zero voltage.

Therefore, during operation of the AAC, each switching element 52 experiences either soft current switching and soft voltage switching, or soft current switching and hard voltage switching.

In a second exemplary application shown in Figure 6, the switching element 52 forms part of a Series Bridge Converter (SBC). The SBC includes a plurality of limbs connected in series between DC terminals that are connectable to a DC network. Each limb includes a phase element 62, each of which includes a plurality of switching elements 52 to interconnect the DC network and a multi-phase AC network. More specifically, the plurality of switching elements 52 is in the form of two parallel-connected pairs of series-connected switching elements 52, whereby a junction between each pair of series-connected switching elements 52 defines an AC terminal for connection to a respective phase of the multi-phase AC network. Each limb further includes a respective first sub-converter 64 connected in series with each phase element 62 in an electrical block, and a respective second-sub-converter 66 connected in parallel with the electrical block. In use, each first sub-converter 64 is operable to act as a waveform synthesizer to modify a DC voltage presented to a DC side of the corresponding phase element 62, and each second sub-converter 66 is operable to act as a waveform synthesizer to modify a DC voltage presented to the DC network.

During such switching of each limb portion of the SBC, the corresponding switching element 52 commutates at zero voltage on a repetition cycle, typically a frequency of 50 Hz.

The current experienced by each switching element 52 at its commutation may be either a zero (or substantially zero) current or a non-zero current depending on the reactive power being exchanged with an AC network connected to the AC terminals of the SBC. If the reactive power exchanged with the AC network is zero (or substantially zero), then the current experienced by each switching element 52 at its commutation is a zero (or substantially zero) current. If the reactive power exchanged with the AC network is non-zero, then the current experienced by each switching element 52 at its commutation is a non-zero current.

Therefore, during operation of the SBC, each switching element 52 experiences either soft current switching and soft voltage switching, or hard current switching and soft voltage switching.

Soft switching of each switching element 52 advantageously results in minimised switching losses (i.e. high efficiency) and simplification of the design of the switching element 52.

In addition, each switching element 52 during its use in the AAC and SBC arrangements experience portions of sinusoidal voltage and current waveforms. The voltage experienced by each switching element 52 is unidirectional due to the presence of the anti-parallel connected diode in each switching element 52. The current experienced by each switching element 52 is alternating current that flows in one direction through the IGBT and in the reverse direction through the anti-parallel diode.

Each switching element 52 in the AAC and SBC arrangements may, under emergency or abnormal conditions, be exposed to both hard voltage and hard current commutation events on a single-shot and infrequent basis.

The switching element 52 therefore experiences a wide range of actual in-service current and voltage conditions during its use in the AAC and SBC arrangements.

Typically the switching element 52 must comply with various testing requirements, which are identical or closely similar to actual in-service current and voltage conditions, in order to be certified for service operation.

Therefore, in order to check whether the switching element 52 complies with such testing requirements, the synthetic test circuit 30 is controlled to perform an electrical test on the switching element 52 that involves creation of test conditions including one or more of:
- sinusoidal current and voltage waveforms representative of actual in-service operation;
- a unidirectional, positive voltage waveform;
- a bidirectional current waveform;
- current and voltage waveforms representative of repetitive zero current switching and zero voltage switching;
- current and voltage waveforms representative of repetitive zero current switching and hard voltage switching;
- current and voltage waveforms representative of repetitive hard current switching and zero voltage switching;
- current and voltage waveforms representative of single-shot (non-repetitive) hard current switching and hard voltage switching.

The capability of the chain-link converter 44 to provide complex voltage waveforms thereacross enables the current and voltage injection circuits 36,40 to inject a wide range of current and voltage waveforms into the switching element 52 under test, and so enables the synthetic test circuit 30 to readily and reliably create test current and voltage conditions that are identical or closely similar to the above actual in-service current and voltage conditions.

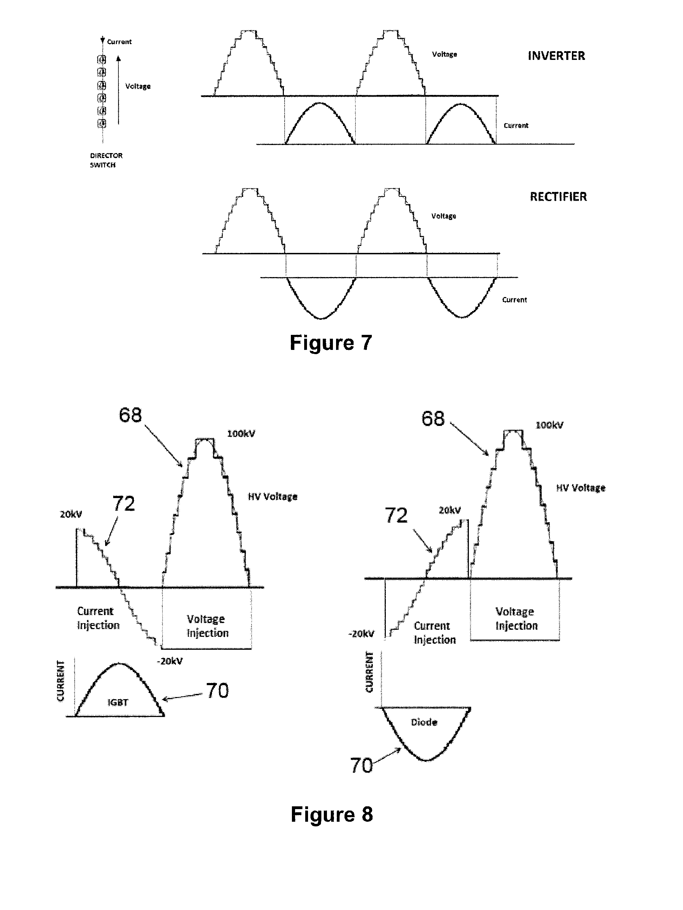

Figure 7 illustrates the actual in-service voltage and current conditions experienced by each switching element 52 when it undergoes soft current switching and soft voltage switching in both inverter and rectifier modes of the AAC and SBC arrangements.

In order to create test current and voltage conditions that are identical or closely similar to the actual in-service current and voltage conditions shown in Figure 7, the controller 50 controls switching of the module switches 54 of the voltage and current injection circuits 40,36 to inject a unidirectional voltage waveform 68 and a unidirectional half-sinusoid current waveform 70 respectively into the switching element 52 under test so as to perform at least one cycle of sequential injections of the unidirectional voltage and current waveforms 68,70 into the switching element 52 under test, as shown in Figure 8.

When the switching element 52 is closed, the controller 50 operates each module of the current injection circuit 36 to selectively bypass each corresponding capacitor 56 and insert each corresponding capacitor 56 into the chain-link converter 44 so as to generate a voltage across the chain-link converter 44, thus modifying a voltage 72 across the inductor 42 so as to control the shape and polarity of the injected current waveform 70.

The voltage 72 across the inductor 42 is controlled to have a zero average component and to start with either a positive section or negative section so as to control the direction of current injected into the switching element 52.

In the embodiment shown, the direction of current is positive when the current is required to flow through the IGBTs of the switching element 52, and the direction of current is negative when the current is required to flow through the anti-parallel connected diodes of the switching element 52.

In this manner the current injection circuit 36 is operated to inject the half-sinusoid current waveform 70 into the switching element 52 under test. Meanwhile the voltage injection circuit 40 is operated to block current from flowing therethrough.

When the current flowing in the switching element 52 under test reaches zero (or substantially zero), the controller 50 opens the isolation switch 38 to switch the current injection circuit 36 out of circuit with the first and second terminals 32,34 so as to selectively isolate the current injection circuit 36 from the switching element 52 under test and the voltage injection circuit 40, and the controller 50 operates each module of the voltage injection circuit 40 to selectively bypass each corresponding capacitor 56 and insert each corresponding capacitor 56 into the chain-link converter 44 so as to generate a voltage across the chain-link converter 44 and thereby inject a unidirectional half-sinusoid voltage waveform into the switching element 52 under test.

As shown in Figure 8, a changeover between an injection of the current waveform 70 into the switching element 52 under test and an injection of the voltage waveform 68 into the switching element 52 under test takes place at a zero or substantially zero value of the current waveform 70 and at a zero or substantially zero value of the unidirectional voltage waveform 68, thus simulating soft current switching and soft voltage switching conditions.

In the above manner the voltage and current injection circuits 40,36 are operated to inject a unidirectional half-sinusoid voltage waveform 68 and a unidirectional half-sinusoid current waveform 70 respectively into the switching element 52 under test so as to perform at least one cycle of sequential injections of the unidirectional voltage and current waveforms 68,70 into the switching element 52 under test. A plurality of cycles of the sequential injections of the voltage and current waveforms 68,70 into the switching element 52 under test may be performed to create test conditions that are identical or closely similar to repetitive soft current switching and soft voltage switching of the switching element 52.

Hence, the synthetic test circuit 30 is capable of creating test conditions that are identical or closely similar to soft current switching and soft voltage switching of the switching element 52, which for example takes place during its use in the AAC and SBC.

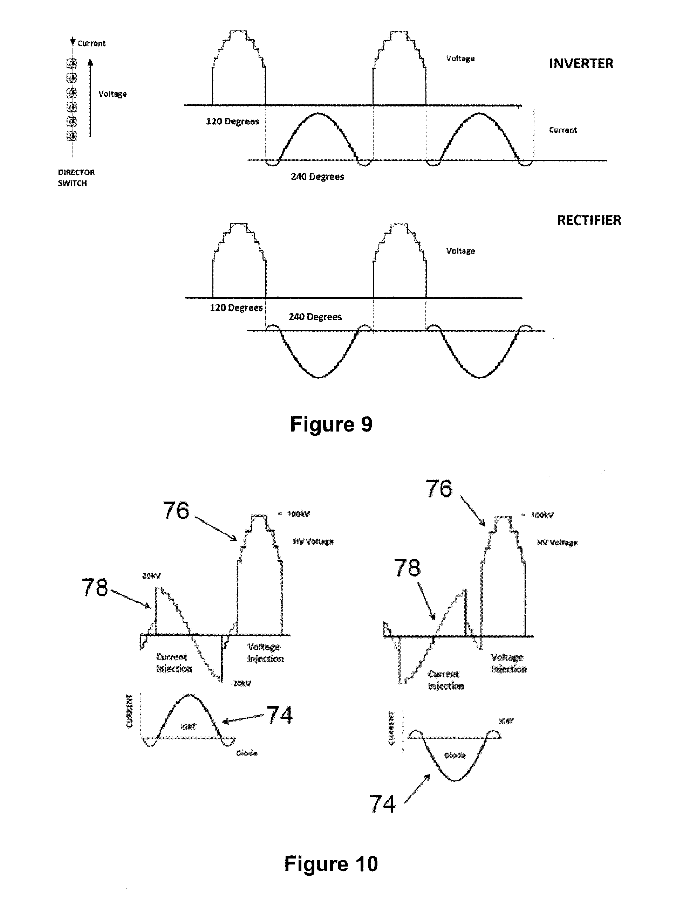

Figure 9 illustrates the actual in-service voltage and current conditions experienced by each switching element 52 when it undergoes soft current switching and hard voltage switching in both inverter and rectifier modes of the AAC.

When the reactive power exchanged with the AC network is non-zero, each switching element 52 of the AAC commutates at zero current and recovers to a step voltage, namely a non-zero voltage. In addition, when DC active harmonic filtering is applied to the AAC, the period of conduction of each switching element 52 increases, e.g. from 180 electrical degrees to 240 degrees per repetition cycle at a frequency of 50Hz. This causes the injected current waveform 74 to vary from being a half-sinusoid current waveform to a more complex current waveform that includes rapid changes between occurrences of IGBT and diode conduction.

In order to create test current and voltage conditions that are identical or closely similar to the actual in-service current and voltage conditions shown in Figure 9, the controller 50 controls switching of the module switches 54 of the voltage and current injection circuits 40,36 to inject a unidirectional voltage waveform 76 and a bidirectional current waveform 74 respectively into the switching element 52 under test so as to perform at least one cycle of sequential injections of the unidirectional voltage and bidirectional current waveforms 76,74 into the switching element 52 under test, as shown in Figure 10.

When the switching element 52 is closed, the controller 50 operates each module of the current injection circuit 36 to selectively bypass each corresponding capacitor 54 and insert each corresponding capacitor 54 into the chain-link converter 44 so as to generate a voltage across the chain-link converter 44, thus modifying a voltage 78 across the inductor 42 so as to control the shape and polarity of the injected current waveform 74.

The voltage 78 across the inductor 42 includes multiple successive voltage portions, each of which is controlled to have a zero average component and to either start with a positive section or negative section so as to control the direction of current injected into the switching element 52.

In one exemplary voltage 78 across the inductor 42, the voltage 78 across the inductor 42 begins with a first voltage portion that starts with a negative section and ends with a positive section, continues with a second voltage portion that starts with a positive section and ends with a negative section, and ends with a third voltage portion that starts with a negative section and ends with a positive section. Thus, the bidirectional current waveform 74 injected into the switching element 52 under test begins with a negative, first current portion (which corresponds to the first voltage portion), continues with a positive, second current portion (which corresponds to the second voltage portion), and ends with a negative, third current portion (which corresponds to the third voltage portion). The direction of current is positive when the current is required to flow through the IGBTs of the switching element 52, and the direction of current is negative when the current is required to flow through the anti-parallel connected diodes of the switching element 52.

In another exemplary voltage 78 across the inductor 42, the voltage 78 across the inductor 42 begins with a first voltage portion that starts with a positive section and ends with a negative section, continues with a second voltage portion that starts with a negative section and ends with a positive section, and ends with a third voltage portion that starts with a positive section and ends with a negative section. Thus, the bidirectional current waveform 74 injected into the switching element 52 under test begins with a positive, first current portion (which corresponds to the first voltage portion), continues with a negative, second current portion (which corresponds to the second voltage portion), and ends with a positive, third current portion (which corresponds to the third voltage portion).

In this manner the current injection circuit 36 is operated to inject the bidirectional current waveform 74 into the switching element 52 under test. Meanwhile the voltage injection circuit 40 is operated to block current from flowing therethrough.

When the current flowing in the switching element 52 under test reaches zero (or substantially zero) at the end of the third current portion, the controller 50 opens the isolation switch 38 to switch the current injection circuit 36 out of circuit with the first and second terminals 32,34 so as to selectively isolate the current injection circuit 36 from the switching element 52 under test and the voltage injection circuit 40, and the controller 50 operates each module of the voltage injection circuit 40 to selectively bypass each corresponding capacitor 54 and insert each corresponding capacitor 54 into the chain-link converter 44 so as to generate a voltage across the chain-link converter 44 and thereby inject a unidirectional half-sinusoid voltage waveform 76 into the switching element 52 under test.

As shown in Figure 10, a changeover between an injection of the bidirectional current waveform 74 into the switching element 52 under test and an injection of the unidirectional voltage waveform 76 into the switching element 52 under test takes place at a zero or substantially zero value of the bidirectional current waveform 74 and at a non-zero value of the unidirectional voltage waveform 76, thus simulating soft current switching and hard voltage switching conditions.

In the above manner the voltage and current injection circuits 40,36 are operated to inject a unidirectional voltage waveform 76 and a bidirectional current waveform 74 respectively into the switching element 52 under test so as to perform at least one cycle of sequential injections of the unidirectional voltage and bidirectional current waveforms 76,74 into the switching element 52 under test. A plurality of cycles of the sequential injections of the voltage and current waveforms 76,74 into the switching element 52 under test may be performed to create test conditions that are identical or closely similar to repetitive soft current switching and hard voltage switching of the switching element 52.

Hence, the synthetic test circuit 30 is capable of creating test conditions that are identical or closely similar to soft current switching and hard voltage switching of the switching element 52, which for example takes place during its use in the AAC.

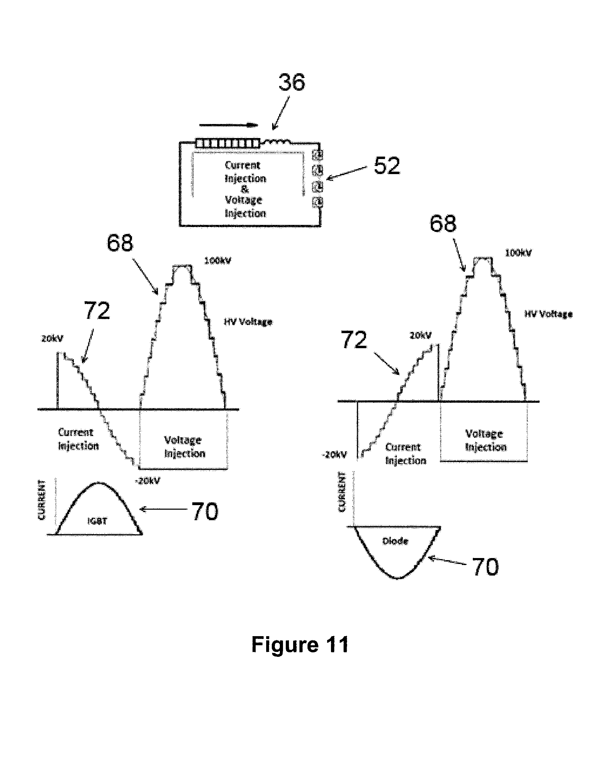

Figure 11 illustrates the operation of the current injection circuit 36 to inject both voltage and current waveforms 68,70 into a switching element 52 under test to simulate the actual in-service voltage and current waveforms of Figure 7.

In particular, the controller 50 operates the current injection circuit 36 to inject both voltage and current waveforms 68,70 into the switching element 52 under test so as to perform at least one cycle of sequential injections of the voltage and current waveforms 68,70 into the switching element 52 under test. Meanwhile the voltage injection circuit 40 is operated to block current from flowing therethrough.

The shape of the injected voltage and current waveforms 68,70 are the same as the ones described above with reference to Figure 8.

The number of modules in the chain-link converter 44 of the current injection circuit may be varied to modify the voltage rating of the chain-link converter 44 in order to meet the voltage testing requirements of the switching element 52 under test.

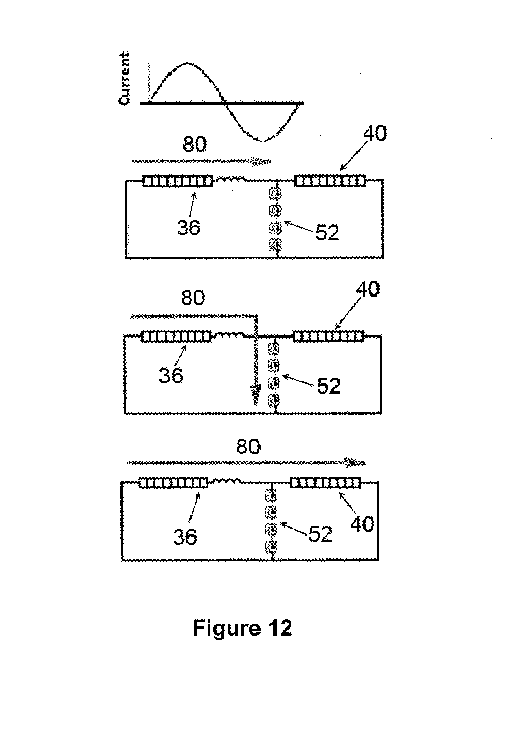

Figure 12 illustrates the operation of the voltage and current injection circuits 40,36 to create a step change in current injected into the switching element 52 under test to create test conditions corresponding to actual in-service hard current switching conditions.

When the required test conditions involves turning the switching element 52 on or off at a non-zero current (up to peak rated current), the controller 50 may operate the current injection circuit 36 to inject a continuous sinusoidal current waveform 80 into the switching element 52 under test. Meanwhile the controller 50 operates the voltage injection circuit 40 to selectively permit the injected current waveform 80 to flow through the voltage injection circuit 40 and block the injected current waveform from flowing through the voltage injection circuit 40. By operating the voltage injection circuit 40 in this manner, the injected current waveform 80 is allowed to commutate between the switching element 52 under test and voltage injection circuit 40 (as shown in Figure 12) so as to cause the switching element 52 under test to experience a step change in current and thereby enable the switching element 52 to experience hard current switching.

Such commutation of the injected current waveform 80 between the switching element 52 under test and voltage injection circuit 40 overcomes the difficulty faced by the inductor 42 in allowing the step change in current required to create hard current switching test conditions, and thereby provides the synthetic test circuit 30 with a reliable means for creating test current conditions that are identical or closely similar to actual in-service current conditions in which the switching element 52 experiences a changeover at a non-zero value of the current waveform 80.

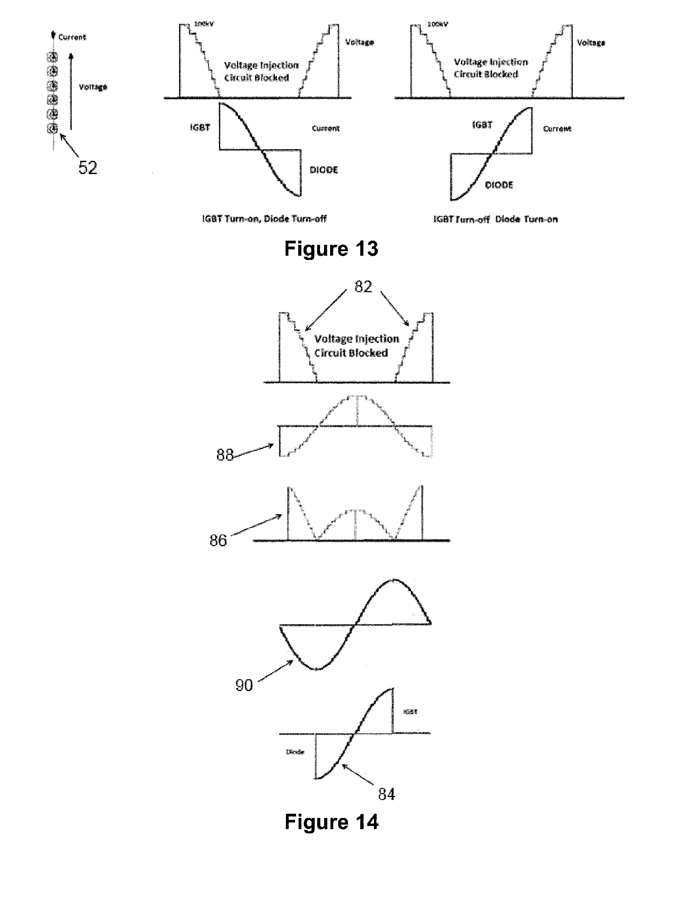

Figures 13 and 14 illustrates the operation of the voltage and current injection circuits 40,36 to inject respective voltage and current waveforms 82,84 into a switching element 52 under test to create test conditions that are identical or closely similar to actual in-service hard current switching and soft voltage switching of the switching element 52 during its use in the SBC.

In order to create such test current and voltage conditions, the controller 50 controls switching of the module switches 54 of the voltage and current injection circuits 40,36 to inject a unidirectional voltage waveform 82 and a bidirectional half-sinusoid current waveform 84 respectively into the switching element 52 under test so as to perform at least one cycle of sequential injections of the unidirectional voltage and bidirectional current waveforms 82,84 into the switching element 52 under test, as shown in Figure 14.

The controller 50 operates each module of the current injection circuit 36 to selectively bypass each corresponding capacitor 54 and insert each corresponding capacitor 54 into the chain-link converter 44 so as to generate a voltage 86 across the chain-link converter 44, thus modifying a voltage 88 across the inductor 42 so as to control the shape and polarity of the injected current waveform 84. The voltage 88 across the inductor 42 is controlled to be in the form of a continuous sinusoidal voltage waveform 88 that leads the resultant continuous sinusoidal current waveform 90 flowing in the inductor 42 by 90 electrical degrees. The continuous sinusoidal current waveform 90 flowing in the inductor 42 starts with one of positive and negative current sections and ends with the other of the positive and negative current sections positive section or negative section so as to control the direction of current injected into the switching element 52.

Initially the controller 50 operates each module of the voltage injection circuit 40 to selectively bypass each corresponding capacitor 56 and insert each corresponding capacitor 56 into the chain-link converter 44 so as to generate a voltage across the chain-link converter 44 and thereby inject a first quarter-sinusoid portion of the unidirectional voltage waveform 82 into the switching element 52 under test. The first quarter-sinusoid portion of the unidirectional voltage waveform 82 starts at a peak non-zero value and ends at a zero value. Meanwhile the controller 50 operates the voltage injection circuit 40 to permit the injected current waveform 84 to flow through the voltage injection circuit and thereby cause the injected current waveform 84 to bypass the switching element 52 under test in the same manner as described above with reference to Figure 12.

When the first quarter-sinusoid portion of the unidirectional voltage waveform 82 injected into the switching element 52 under test reaches its zero value, the controller 50 operates the voltage injection circuit 40 to block the injected current waveform 84 from flowing through and thereby permit the injected current waveform 84 to commutate from the voltage injection circuit to the switching element 52 under test, thus allowing the injected current waveform 84 to flow through the switching element 52 under test. This in turn causes the switching element 52 under test to experience a step change in current and thereby enable the switching element 52 to experience hard current switching.

Accordingly the bidirectional half-sinusoid current waveform 84 injected into the switching element 52 under test starts with one of positive and negative current sections and ends with the other of the positive and negative current sections. The bidirectional half-sinusoid current waveform 84 starts at one peak non-zero value and ends at another peak non-zero value. The direction of current is positive when the current is required to flow through the IGBTs of the switching element 52, and the direction of current is negative when the current is required to flow through the anti-parallel connected diodes of the switching element 52.

When the current flowing in the switching element 52 under test reaches its second peak non-zero value, the controller 50 operates the voltage injection circuit 40 to permit the injected current waveform 84 to flow through the voltage injection circuit 40 and thereby cause the injected current waveform 84 to commutate from the switching element 52 under test to the voltage injection circuit 40, thus allowing the injected current waveform 84 to again bypass the switching element 52 under test. This in turn causes the switching element 52 under test to experience another step change in current.

The controller 50 then operates each module of the voltage injection circuit 40 to selectively bypass each corresponding capacitor 56 and insert each corresponding capacitor 56 into the chain-link converter 44 so as to generate a voltage across the chain-link converter 44 and thereby again inject a second quarter-sinusoid portion of the unidirectional voltage waveform 82 into the switching element 52 under test. The second quarter-sinusoid portion of the unidirectional voltage waveform 82 starts at a zero value and ends at a peak non-zero value.

As shown in Figure 13, each changeover between an injection of the bidirectional half-sinusoid current waveform 84 into the switching element 52 under test and an injection of the unidirectional voltage waveform 82 into the switching element 52 under test takes place at a non-zero value of the bidirectional half-sinusoid current waveform 84 and at a zero or substantially zero value of the unidirectional voltage waveform 82.

In order to provide the continuous sinusoidal current waveform 90 in the inductor 42 and inject the bidirectional half-sinusoid current waveform 84 into the switching element 52 under test, the chain-link converter 44 of the current injection circuit is operated to generate a voltage waveform 86 thereacross that is the sum of the voltage 88 across the inductor and the voltage across the switching element 52 under test.

In the above manner the voltage and current injection circuits 40,36 are operated to inject a unidirectional voltage waveform 82 and a bidirectional half-sinusoid current waveform 84 respectively into the switching element 52 under test so as to perform at least one cycle of sequential injections of the unidirectional voltage and bidirectional current waveforms 82,84 into the switching element 52 under test. Again, a plurality of cycles of the sequential injections of the voltage and current waveforms 82,84 into the switching element 52 under test may be performed to create test conditions that are identical or closely similar to repetitive hard current switching and soft voltage switching of the switching element 52.

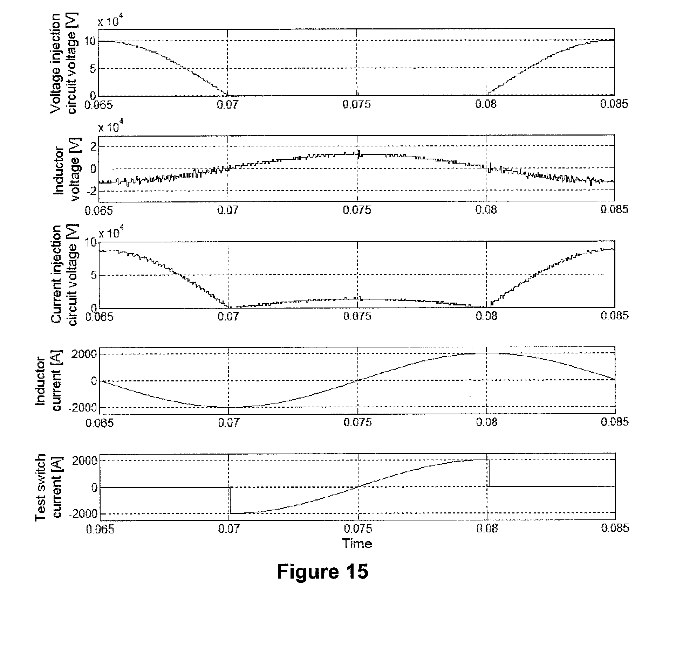

Figure 15 illustrates, in graph form, simulation results of the creation of the aforementioned test conditions that are identical or closely similar to hard current switching and soft voltage switching of the switching element 52. It can be seen from Figure 15 that the synthetic test circuit 30 is capable of creating test conditions that are identical or closely similar to hard current switching and soft voltage switching of the switching element 52, which for example takes place during its use in the SBC.

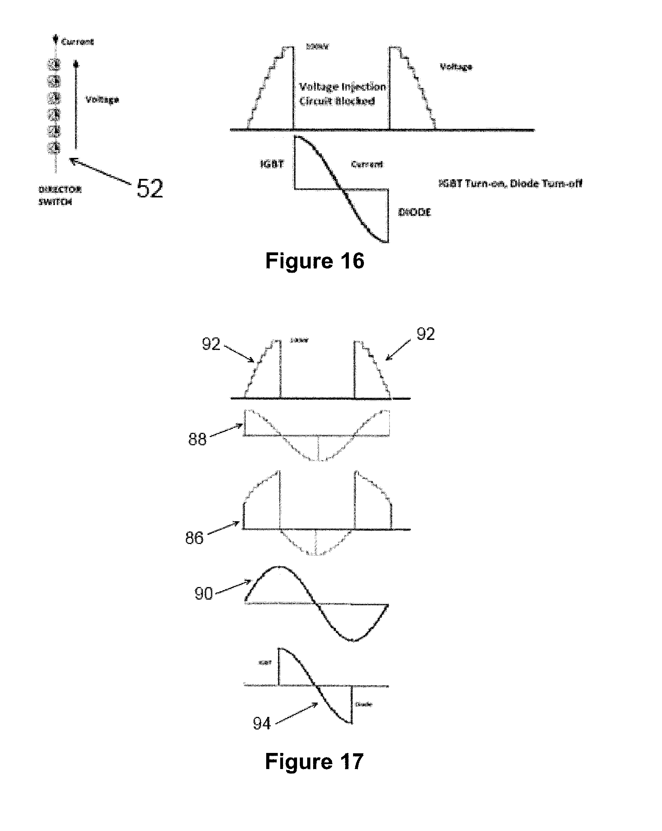

Figures 16 and 17 illustrates the operation of the voltage and current injection circuits 40,36 of Figure 1 a to inject respective voltage and current waveforms 92,94 into a switching element 52 under test to create test conditions that are identical or closely similar to actual in-service hard current switching and hard voltage switching of the switching element 52 during its use in the AAC and SBC.

As mentioned earlier, each switching element 52 in the AAC and SBC arrangement may, under emergency or abnormal conditions, be exposed to both hard voltage and hard current commutation events on a single-shot and infrequent basis.

The unidirectional voltage and bidirectional half-sinusoid current waveforms 92,94 injected into the switching element 52 under test are generated in the same manner as the ones 82,84 described above with reference to Figures 13 and 14, except that the first quarter-sinusoid portion of the unidirectional voltage waveform 92 starts at a zero value and ends at a peak non-zero value, and the second quarter-sinusoid portion of the unidirectional voltage waveform 94 starts at a peak non-zero value and ends at a zero value.

As such, as shown in Figures 16 and 17, each changeover between an injection of the bidirectional half-sinusoid current waveform 94 into the switching element 52 under test and an injection of the unidirectional voltage waveform 92 into the switching element 52 under test takes place at a non-zero value of the bidirectional half-sinusoid current waveform 94 and at a non-zero value of the unidirectional voltage waveform 92.

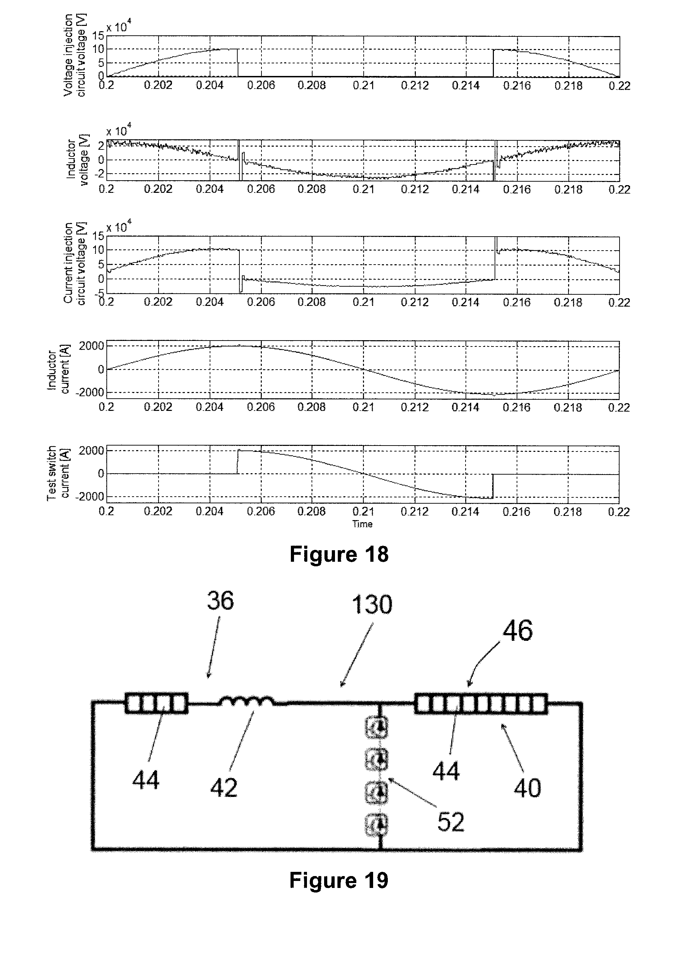

Figure 18 illustrates, in graph form, simulation results of the creation of the aforementioned test conditions that are identical or closely similar to hard current switching and hard voltage switching of the switching element 52. It can be seen from Figure 18 that the synthetic test circuit 30 is capable of creating test conditions that are identical or closely similar to hard current switching and half voltage switching of the switching element 52, which for example takes place during its use in the AAC and SBC.

In view of the foregoing the provision of the chain-link converters 44 in the current and voltage injection circuits 36,40 therefore results in a synthetic test circuit 30 that is not only capable of performing high quality electrical testing, but also has the flexibility to perform an electrical test on a broad range of switching elements 52 with different ratings. This is because the capability of the chain-link converter 44 to generate a voltage waveform thereacross using a step-wise approximation allows the current and voltage injection circuits 36,40 to inject current and voltage waveforms of varying levels into the switching element 52 under test, and thus renders the synthetic test circuit 30 capable of electrically testing various switching elements 52 across a wide range of ratings.

In addition the modular arrangement of the chain-link converter 44 means that the number of modules in the chain-link converter 44 can be readily scaled up or down to modify the voltage capability of the chain-link converter 44 to match the testing requirements of the switching element 52 under test, without having to make significant changes to the overall design of the synthetic test circuit 30.

A synthetic test circuit according to a second embodiment of the invention is shown in Figure 19, and is designated generally by the reference numeral 130. The synthetic test circuit of Figure 19 is similar in structure and operation to the synthetic test circuit 30 of Figures 1 a and 1 b, and like features share the same reference numerals.

The synthetic test circuit 130 of Figure 19 differs from the synthetic test circuit 30 of Figures 1 a and 1 b in that the voltage rating of the chain-link converter 44 of the current injection circuit 36 exceeds the voltage rating of the chain-link converter 44 of the voltage injection circuit 40. This allows the current injection circuit 36 to be operated to selectively provide a blocking voltage to isolate the current injection circuit 36 from the voltage injection circuit 40 and switching element 52 under test, thus obviating the need for the isolation switch 38.

In other embodiments of the invention, it is envisaged that the current injection circuit 36 may include a plurality of parallel-connected current sources. The number of parallel-connected current sources in the current injection circuit 36 may vary to adapt the current capability of the current injection circuit 36 for compatibility with the current rating and test current conditions of the switching element 52 under test.

It will be appreciated that the above type of switching element 52 and the above exemplary applications of the switching element 52 described in this specification are merely chosen to illustrate the working of the invention. Accordingly it will also be appreciated that the invention is intended to extend to the use of the synthetic test circuit 30,130 with other types of switching elements 52 that may be used in other types of switching applications, which are not limited to the field of HVDC power transmission.

It will be also appreciated that the shapes of the voltage and current waveforms described in this specification are merely chosen to illustrate the working of the invention. Accordingly it will also be appreciated that other shapes of the voltage and current waveforms may be used with the synthetic test circuit 30,130 according to the invention.

## Claims

1. A synthetic test circuit, for performing an electrical test on a device under test, comprising:
a terminal connectable to the device under test;
a voltage injection circuit operably connected to the terminal, the voltage injection circuit including a voltage source, the voltage source including a chain-link converter, the chain-link converter including a plurality of modules, each module including at least one energy storage device; and
a controller being configured to operate each module of the voltage injection circuit to selectively bypass the or each corresponding energy storage device and insert the or each corresponding energy storage device into the chain-link converter so as to generate a voltage across the chain-link converter and thereby operate the voltage injection circuit to inject a unidirectional voltage waveform into the device under test.

2. A synthetic test circuit according to any preceding claim wherein the voltage source is a unidirectional voltage source.

3. A synthetic test circuit according to any preceding claim wherein each module of the voltage injection circuit includes a plurality of module switches connected with the or each energy storage device to define a unipolar module that can provide zero or positive voltages, optionally wherein each module of the voltage injection circuit includes a plurality of module switches connected in parallel with an energy storage device in a half-bridge arrangement to define a unipolar module that can provide zero or positive voltages, and further optionally wherein each module of the voltage injection circuit includes a plurality of module switches connected in parallel with an energy storage device in a half-bridge arrangement to define a 2-quadrant unipolar module that can provide zero or positive voltages and can conduct current in two directions.

4. A synthetic test circuit according to any preceding claim further including a current injection circuit operably connected to the terminal, the current injection circuit including a current source, the current source including a chain-link converter, the chain-link converter including a plurality of modules, each module including at least one energy storage device,
wherein the controller is configured to operate each module of the current injection circuit to selectively bypass the or each corresponding energy storage device and insert the or each corresponding energy storage device into the chain-link converter so as to generate a voltage across the chain-link converter and thereby operate the current injection circuit to inject a current waveform into the device under test.

5. A synthetic test circuit according to Claim 4 wherein the controller is configured to operate each module of the current injection circuit to selectively bypass the or each corresponding energy storage device and insert the or each corresponding energy storage device into the chain-link converter so as to generate a voltage across the chain-link converter and thereby operate the current injection circuit to inject a voltage waveform into the device under test.

6. A synthetic test circuit according to Claim 4 or Claim 5 wherein the current source is a bidirectional current source.

7. A synthetic test circuit according to any of Claims 4 to 6 wherein the current source includes an inductor connected to the chain-link converter.

8. A synthetic test circuit according to any of Claims 4 to 7 wherein each module of the current injection circuit includes a plurality of module switches connected with the or each energy storage device to define a bipolar module that can provide negative, zero or positive voltages, optionally wherein each module of the current injection circuit includes a plurality of module switches connected in parallel with an energy storage device in a full-bridge arrangement to define a bipolar module that can provide negative, zero or positive voltages, and further optionally wherein each module of the current injection circuit includes a plurality of module switches connected in parallel with an energy storage device in a full-bridge arrangement to define a 4-quadrant bipolar module that can provide negative, zero or positive voltages and can conduct current in two directions.

9. A synthetic test circuit according to any of Claims 4 to 8 wherein the controller is configured to operate the voltage and current injection circuits to inject a unidirectional voltage waveform and a current waveform respectively into the device under test so as to perform at least one cycle of sequential injections of the unidirectional voltage and current waveforms into the device under test, and a changeover between an injection of the unidirectional voltage waveform into the device under test and an injection of the current waveform into the device under test takes place at a non-zero, zero or substantially zero value of the current waveform and at a non-zero, zero or substantially zero value of the unidirectional voltage waveform.

10. A synthetic test circuit according to any of Claims 4 to 9 wherein the controller is configured to operate the current injection circuit to inject voltage and current waveforms into the device under test so as to perform at least one cycle of sequential injections of the voltage and current waveforms into the device under test, and a changeover between an injection of the voltage waveform into the device under test and an injection of the current waveform into the device under test takes place at a non-zero, zero or substantially zero value of the current waveform and at a non-zero, zero or substantially zero value of the voltage waveform.

11. A synthetic test circuit according to any of Claims 4 to 10 wherein the controller is configured to operate the voltage injection circuit, when the current injection circuit is operated to inject a current waveform into the device under test, to selectively permit the injected current waveform to flow through the voltage injection circuit and block the injected current waveform from flowing through the voltage injection circuit so as to allow the injected current waveform to commutate between the device under test and voltage injection circuit.

12. A synthetic test circuit according to any preceding claim wherein the synthetic test circuit is rated for performing an electrical test on a switching element, the switching element being preferably a switching element for use in high voltage direct current (HVDC) power transmission.

13. A synthetic test circuit according to any preceding claim wherein the voltage rating of the chain-link converter of the current injection circuit exceeds the voltage rating of the chain-link converter of the voltage injection circuit.
